# EUROPEAN PATENT SPECIFICATION

(11) **EP 0 663 687 B1**
(45) Date of publication and mention of the grant of the patent: **09.07.1997**
(21) Application number: 95100018.1
(22) Date of filing: 02.01.1995
(51) Int. Cl.: H01L 21/00

(54) **Instrument for production of semiconductor and process for production thereof**
Vorrichtung und Verfahren zur Herstellung von Halbleitern
Appareil pour la production de semi-conducteur et procédé pour cette production

(30) Priority: 18.01.1994 JP 19034/94; 28.02.1994 JP 54645/94; 28.02.1994 JP 54646/94
(43) Date of publication of application: 19.07.1995
(73) Proprietor: NISSHINBO INDUSTRIES, INC., Chuo-ku, Tokyo 103 (JP)
(72) Inventor: Saito, Kazuo, c/o Nisshinbo Ind. Inc., Adachi-ku, Tokyo 123 (JP); Ishimatsu, Takeshi, c/o Nisshinbo Ind. Inc., Adachi-ku, Tokyo 123 (JP)
(74) Representative: Laufhütte, Dieter, Dr.-Ing.

(56) References cited:
- DATABASE WPI Week 9345, Derwent Publications Ltd., London, GB; AN 93-357019 & JP-A-5 262 510 (KAGARU KOGYO) 12 October 1993
- IBM TECHNICAL DISCLOSURE BULLETIN., vol.15, no.8, January 1973, NEW YORK US pages 2425 - 2426 'Making Double HeteroJunction Lasers'

## Description

### Background of the Invention

### (1) Field of the Invention

The present invention relates to an instrument for production of semiconductor as well as to a process for producing said instrument.

### (2) Description of the Prior Art

The production of semiconductor consists of many steps and consequantly, various instruments are used for each production steps, however, conventional instruments have some problems.

### A jig for semiconductor

For example, in the steps for semiconductor element production, such as plasma etching step, epitaxy step and the like, it is very important that when a semiconductor wafer makes contact with, for example, a jig used in the steps, the semiconductor wafer is neither stained nor damaged and the properties of the resulting semiconductor are not impaired.

The semiconductor wafer, therefore, is handled very carefully. For example, when the semiconductor wafer is transferred from one step to the next step, the semiconductor wafer is supported by a jig for transfer, such as wafer hand, wafer holder or the like.

These jigs for semiconductor wafer have heretofore been made of a material such as metal, silicon carbide, silicon oxide, zirconium oxide, Teflon (Trademark) or the like. The jigs made of such a material have caused various problems in the contact with the semiconductor wafer.

For example, metals each become a direct staining source for the semiconductor wafer; silicon oxide and zirconium oxide each have a high hardness, are difficult to process, damage the semiconductor wafer, and are expensive; silicon carbide has a high hardness, is difficult to process in high precision, has a low material purity, and causes staining; and Teflon has a problem in purity of material and is difficult to obtain in a high purity.

### A semiconductor wafer dummy

As semiconductor integrated circuits have become finer, a higher integration and a higher density, a plasma etching technique capable of forming a more precise and finer pattern has become more necessary. In this plasma etching, a high-frequency electric current is applied between electrodes to generate a plasma, and a silicon wafer is etched by the plasma. The free radicals and ions of halogen-based gas present in the plasma are attracted by the electric field inside an etching chamber and hit the wafer placed on the opposing electrode, whereby the wafer is etched.

When the above etching is repeated in the chamber of an plasma etching apparatus, the etched silicon and other substances are deposited and adhered on the chamber inside wall, the wafer holder, etc. Therefore, the removal of the deposited or adhered silica, etc. by cleaning becomes necessary. Currently, however, this cleaning is done manually and is generally conducted by wiping off the silicon, etc. by using, for example, a special cloth for semiconductor.

The above manual cleaning by using, for example, a special cloth for semiconductor to wipe off the silicon, etc. requires a long time in cleaning operation and includes a high possibility of secondary staining with human sweat. For these reasons, development of a new cleaning method has become necessary.

In order to solve the above problems, there was proposed a method which comprises fixing, in a plasma etching chamber, a material resistant to plasma etching as a dummy for wafer, and generating a plasma in the chamber to remove the deposited silicon, etc. by etching. As the material resistant to plasma etching, usable as a dummy for wafer, there were studied quartz, silicon carbide, graphite and the like.

However, these materials have problems. That is, quartz cannot be used as a dummy because of the insulation; silicon carbide is expensive and is difficult to process and obtain at a high purity; and graphite has a detrimental drawback of powder detachment and cannot be used as a dummy although it is inexpensive and can easily be processed and obtained at a high purity.

### A boats for supporting semiconductor wafers

Boats for supporting semiconductor wafers are used for various purposes such as (1) supporting of semiconductor wafers thereon, (2) prevention of detachment of said wafers in diffusion treatment in diffusion furnace and (3) transfer of said wafers before and after diffusion treatment. As semiconductor devices have become integrated more highly and have come to possess higher performances in recent years, a necessity has become stronger for a boat for supporting semiconductor wafers which is resistant to a heat treatment at high temperatures and which can be produced easily at a high purity.

Conventional boats for supporting semiconductor wafers include, for example, a boat described in Japanese Patent Application Kokai (Laid-Open) No. 60-107843. In this boat, however, since the constituent members are made of quartz or silicon, there occur strain, cracking and chipping during the formation of grooves (e.g. rod grooves for supporting wafers); as a result, semiconductor wafers are rubbed against the defective portions of rods, resulting in generation of dust, damaging of wafers, and appearance of dislocation defects in wafers.

From the IBM technical disclosure bulletin, January 1973, vol. 15, No. 8, pages 2425-2426 it is known to produce push plates used in the manufacturing of hetero-junction lasers of vitreous carbon in order to prevent melts of semiconductor material from clinging or adhering to such push plates, in order to diminish the incidents of contamination.

In the abstract of JP 5262510 a jig for forming thin film semiconductor devices on a substrate consisting of graphite covered with vitreous carbon is disclosed.

The production of such instruments composed of vitreous carbon is usually expensive.

The object of the present invention is to provide an instrument for production of a semiconductor which can be manufactured at low cost.

Another object of the present invention is to provide a jig for semiconductor which can protect a semiconductor wafer from being stained or damaged, and which can be produced easily at a high purity and at a low cost.

Another object of the present invention is to provide a boat for semiconductor wafers which generates no dust, and which can be produced easily at a high purity and at a low cost.

Still another object of the present invention is to provide a semiconductor dummy used in plasma etching which can easily be processed and obtained at a high purity and at a low cost, and which causes no powder detachment.

The present invention provides
an instrument for production of a semiconductor which is composed substantially of vitreous carbon, wherein the vitreous carbon is obtained by carbonization via heating in vacuum or inert gas from polycarbodiimide resin, wherein the instrument is molded from said resin before carbonization.

The invention further provides a process for producing an instrument for production of a semiconductor, which is composed substantially of a vitreous carbon, wherein the process comprises the steps of molding a polycarbodiimide resin or a composition composed mainly of a polycarbodiimide resin into a shape of an instrument for production of semiconductor and then carbonizing the molded material in vacuum or an inert gas atmosphere.

### Brief Description of the Drawings

Fig. 1 is a side view of an example of the boat for supporting semiconductor wafers according to the present invention.

Fig. 2 is a plan view of a fixing plate used in the boat for supporting semiconductor wafers according to the present invention.

Fig. 3 is a perspective view of a rod used in the boat for supporting semiconductor wafers according to the present invention.

### Detailed Description of the Invention

The present invention is hereinafter described in detail.

An instrument for production of semiconductor of the present invention includes various variations, such as parts, instruments and tools of a producing equipment or a inspection equipment that come in direct contact with the semiconductor, the semiconductor device or the semiconductor wafer during their production or inspection stage, as well as parts, instruments and tools of a producing equipment or a inspection equipment that does not come in direct contact with the semiconductor, the semiconductor device or the semiconductor wafer and does not produce contaminant.

Such an instrument for production of semiconductor is examplified by a jig for semiconductor, a semiconductor wafer dummy and a boat for supporting semiconductor wafers etc.

The jig for semiconductor mentioned in the present invention includes jigs for wafer transfer or wafer inspection, such as wafer hand, wafer holder and the like as mentioned above. These jigs have been produced by processing a metal, silicon carbide, silicon oxide, zirconium oxide, Teflon or the like.

The semiconductor wafer dummy mentioned in the present invention has been used in a method which comprises fixing, in a plasma etching chamber, the semiconductor wafer dummy made of a material resistant to plasma etching, and generating a plasma in the chamber to remove the deposited silicon, etc. by etching. As the material of a dummy for wafer, there were studied quartz, silicon carbide, graphite and the like.

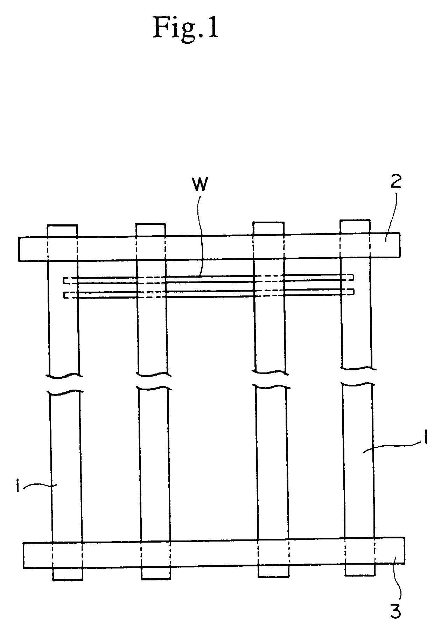

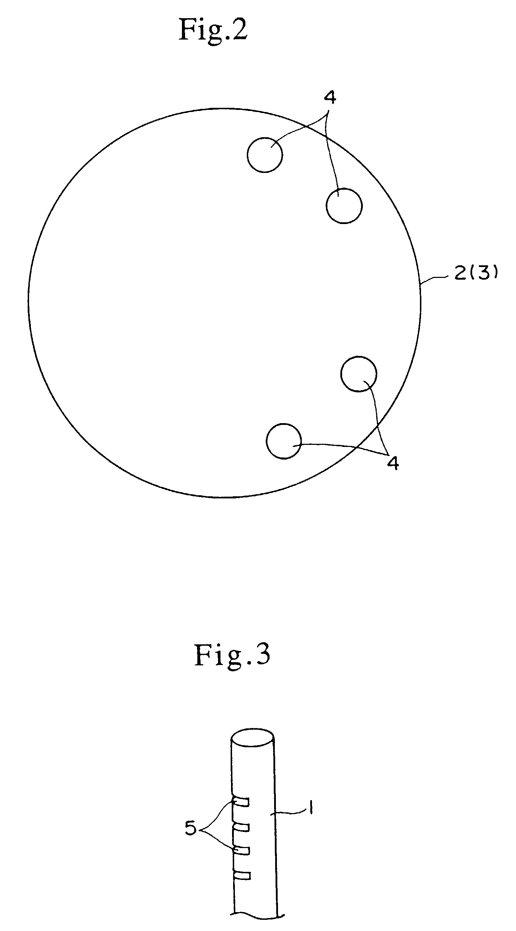

The boat for supporting semiconductor wafers mentioned in the present invention is, for example, as shown in Fig. 1, basically constituted by the main members, i.e. four supporting rods 1 and a pair of fixing plates 2 and 3. As shown in Fig. 2, the four supporting rods 1 are fixed by each being inserted into one of the four holes 4 formed in each of the fixing plates 2 and 3, whereby the boat is self-supported.

As shown in Fig. 3, each supporting rod 1 has, at the side, a plurality of grooves 5 for supporting semiconductor wafers. When the supporting rods 1 and the fixing plates 2 and 3 are assembled into a boat for supporting semiconductor wafers, the grooves of the supporting rods 1 are directed roughly toward the center of the boat, whereby semiconductor wafers W can be supported between the fixing plates 2 and 3 by the grooves 5 as shown in Fig. 1. As the material of a boat, there were used quartz or silicon,

In the present invention, the instrument for production of semiconductor is made substantially of a vitreous carbon derived from polycarbodiimide resin. In case of the above-mentioned boat for supporting semiconductor wafers, not only the main members (supporting rods and fixing plates) but also the auxiliary members such as grip and the like (if they are used) are each made of a vitreous carbon derived from polycarbodiimide resin.

The polycarbodiimide resin can be produced by a per se known process or a process similar thereto [e.g. , U.S. Patent No. 2,941,956; Japanese Patent Publication No. 47-33279; J. Org. Chem., 28, 2069-2075 (1963); Chemical Review 1981, Vol. 81, No. 4, 619-621]. It can easily be produced, for example, by subjecting an organic diisocyanate to a condensation reaction (carbon dioxide is removed in the reaction) in the presence of a carbodiimidization catalyst.

The organic diisocyanate used in the above production of the polycarbodiimide resin may be any of an aliphatic type, an alicyclic type, an aromatic type, an aromatic-aliphatic type, etc. These may be used singly or in admixture of two or more (in the latter case, a copolycarbodiimide resin is obtained).

The polycarbodiimide resin used in the present invention includes a homopolymer or a copolymer each composed of at least one repeating unit represented by the following formula

-R-N=C=N-

wherein R represents a residual group of organic diisocyanate. Herein, the residual group of organic diisocyanate refers to a portion of organic diisocyanate which is the organic diisocyanate molecule minus two isocyanate groups (two NCOs).

The above R is preferably a residual group of aromatic diisocyanate. Specific examples of such a polycarbodiimide resin are the followings.

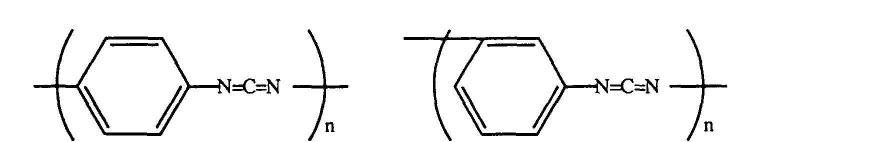

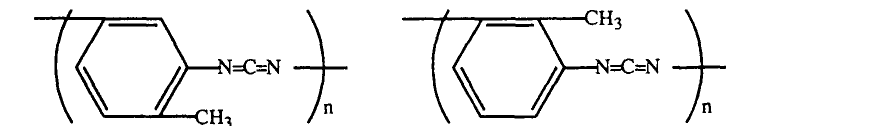

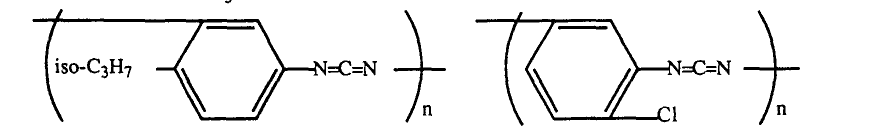

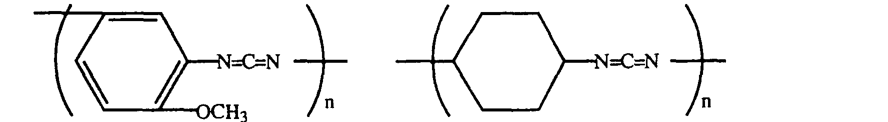

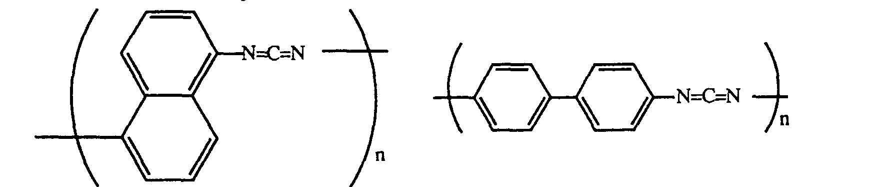

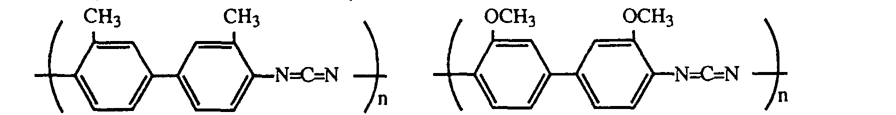

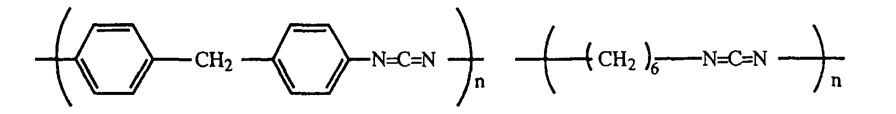

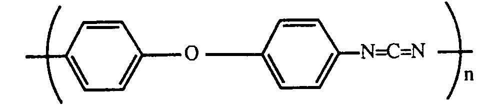

In each of the above formulas, n is 10-10,000, preferably 50-5,000; and the terminal(s) of each polycarbodiimide resin may be blocked with a monoisocyanate or the like.

The polycarbodiimide resin can be obtained in the form of a solution, or as a powder precipitated from the solution. The polycarbodiimide obtained in the form of a solution is used as it is or after removing the solvent; and the polycarbodiimide resin obtained as a powder is used as it is or after being dissolved in a solvent to convert it into a solution.

In the present invention, the polycarbodiimide resin powder or solution is first made into a molded material having a shape of an instrument for production of semiconductor (such as a jig for semiconductor (typically, a wafer hand or a wafer holder), a semiconductor wafer dummy or a boat for supporting semiconductor wafers). The method of forming the molded material is not particularly restricted and can be a method generally used in production of such an instrument for production of semiconductor, such as injection molding, compression molding, liquid injection molding, vacuum molding or the like.

Then, the molded material having a shape of an instrument for production of semiconductor is heated to carbonize the polycarbodiimide resin, whereby an intended instrument for production of semiconductor according to the present invention can be produced. The carbonization step can be conducted in vacuum or in an inert gas atmosphere such as nitrogen gas or the like. The final firing temperature is preferably 1,000-3,000°C. The molded material may be subjected to preliminary heating, before carbonization.

The thus obtained an instrument for production of semiconductor according to the present invention is made substantially of a vitreous carbon derived from the polycarbodiimide resin, having a bulk density of 1.51-1.8 g/cm³, a bending strength of 1,800-4,000 kg/cm², a Shore hardness of 121-140, a porosity of 0-0.09% and an ash content of 0-4 ppm. Therefore, the present invention is able to provide an instrument for production of semiconductor which is free from the problems of the prior art.

For example, the jig protects a semiconductor wafer from being stained or damaged and can easily be produced at a high purity and at a low cost. The present jig for semiconductor can also be used as a jig for magnetic tape.

The semiconductor dummy used in plasma etching is processed easily and obtained at a high purity and at a low cost, and causes no powder detachment. This semiconductor dummy is used in a method for cleaning of plasma etching chamber inside and the like by fixing the wafer dummy inside the chamber of a plasma etching apparatus, and then generating a plasma inside the chamber.

The boat for semiconductor wafers generates no dust, and can be produced easily at a high purity and at a low cost. The boat is used for various purposes such as (1) supporting of semiconductor wafers thereon, (2) prevention of detachment of said wafers in diffusion treatment in diffusion furnace and (3) transfer of said wafers before and after diffusion treatment.

The present invention is hereinafter described in more detail by way of Example.

### Example 1

54 g of a 2,4-tolylene diisocyanate/2,6-tolylene diisocyanate mixture (80:20) was reacted in a 500 ml of tetrachloroethylene in the presence of 0.12 g of a carbodiimidization catalyst (1-phenyl-3-methylphospholene oxide) at 120°C for 4 hours to obtain a polycarbodiimide resin solution. The resin solution was injected into a metal mold corresponding to the shape of an intended jig for semiconductor, and molding was conducted at 60°C for 20 hours and then at 120°C for 10 hours. The resulting molded material was taken out of the mold. The molded material was heat-treated at 200°C for 10 hours and then heated to 2,000°C in an argon atmosphere, whereby a wafer holder of 50 mm x 65 mm x 5 mm (thickness), which is composed substantially of a vitreous carbon derived from polycarbodiimide resinwas produced.

The wafer holder had excellent properties, i.e. a bulk density of 1.55 g/cm³, a bending strength of 2,700 kg/cm², a Shore hardness of 130, a porosity of 0% and an ash (impurity) content of 2 ppm.

Using the wafer holder, 1,000 and 2,000 semiconductor silicon wafers were transferred. The results are shown in Table 1.

### Comparative Example 1

A jig for semiconductor having the same shape and size as the jig of Example 1 was produced using silicon carbide. The jig was subjected to the same test as in Example 1. The results are shown in Table 1.

**Table 1**

| | Wafer staining | | Wafer damage | |
|---|---|---|---|---|
| | 1000 times | 2000 times | 1000 times | 2000 times |
| Example 1 | No | No | No | No |
| Comparative Example 1 | 27 wafers stained | 130 wafers stained | 20 wafers damaged | 123 wafers damaged |

As stated above, the present jig for semiconductor is made substantially of a vitreous carbon derived from polycarbodiimide resin, neither stains nor damages a semiconductor wafer, and is low in wear.

### Example 2

A polycarbodiimide resin obtained in Example 1 was casted into a metallic mold which corresponded to the shape of a wafer dummy to be obtained, and was heat-treated at 60°C for 20 hours and then at 120°C for 10 hours for molding. The resulting molded material was taken out of the mold and heat-treated at 200°C for 10 hours. Then, the material was heated to 2,000°C in nitrogen gas to obtain a semiconductor wafer dummy of 6 inches in diameter. The wafer dummy was made of a vitreous carbon having an apparent density of 1.55 g/cm³, a Shore hardness of 125, a bending strength of 2,500 kg/cm², a porosity of 0.01% and an ash content of 2 ppm.

100 silicon wafers were subjected to an etching treatment under the following conditions, using a plasma etching apparatus made by Tokyo Electron.

### Etching conditions

Carrier gas: nitrogen
Etching gas: CF₂/O₂ mixed gas
Vacuum: 105 Pa (0,8 Torr)
Temperature: 250°C
RF power: 13.56 MHz, 3.5 A

Then, the wafer dummy obtained above was set in the plasma etching apparatus in place of the silicon wafer, and an etching treatment for cleaning was conducted for 1 minute. Thereafter, 100 silicon wafers were treated and they were measured for number of dusts and number of dislocation defects. The results are shown in Table 2. Incidentally, "number of dusts" refers to the average of numbers of dusts each having a size not smaller than 0.16 nm, and "number of dislocation defects" refers to the number of wafers (of 100 reated wafers) in which dislocation defects were found. (The same applies to hereinafter.)

### Comparative Example 2

The procedure of Example 2 was repeated except that no cleaning step using a semiconductor wafer dummy was conducted. The results are shown in Table 2.

### Comparative Example 3

The procedure of Example 2 was repeated except that instead of the cleaning step using a semiconductor wafer dummy, there was conducted wiping-off with a special cloth for semiconductor and methanol. The results are shown in Table 2.

**Table 2**

| | Number of dusts | Number of dislocation defects |
|---|---|---|
| Example 2 | 2 | 0 |
| Comparative Example 2 | 850 | 41 |
| Comparative Example 3 | 1567 | 65 |

As stated above, the semiconductor wafer dummy of the present invention is substantially made of a vitreous carbon, therefore, the dummy generates no dust and hardly causes staining of wafer, i.e. formation of dislocation defects.

### Example 3

A polycarbodiimide resin obtained in Example 1 was casted into metallic molds corresponding to the supporting rods and fixing plates shown in Figs. 1 to 3, and heat-treated at 60°C for 12 hours and then at 120°C for 10 hours. The resulting molded materials were taken out of the molds and heat-treated at 200°C for 10 hours. The resulting materials were heated to 2,000°C in nitrogen gas to obtain main members of a boat for supporting semiconductor wafers. The main members were made of a vitreous carbon having an apparent density of 1.55 g/cm³, a Shore hardness of 125, a bending strength of 2,000 kg/cm², a porosity of 0.01% and an ash content of 2 ppm.

The main members were assembled into a boat for supporting semiconductor wafers. Using the boat, semiconductor silicon wafers were transferred under the following conditions, after which the dust and dislocation defects present on the wafers were examined. That is, 100 semiconductor silicon wafers were supported on the boat and inserted into a diffusion furnace maintained at 900°C, at a speed of 200 mm/min.

The temperature inside the furnace was elevated to 1,200°C at a rate of 10°C/min. At this temperature for 1 hour, the wafers supported on the boat were subjected to dry oxidation. Then, the temperature inside the furnace was lowered to 900°C at a rate of 5°C/min. Thereafter, the wafers on the boat were taken out of the furnace at a speed of 200 mm/min. The results are shown in Table 3.

### Comparative Example 4

Main members (each made of quartz) were assembled into a boat for supporting semiconductor wafers. Using the boat, semiconductor silicon wafers were transferred under the same conditions as in Example 3, after which the dust and dislocation defects present on the wafers were examined. The results are shown in Table 3.

**Table 3**

| | Number of dusts | Number of dislocation defects |
|---|---|---|
| Example 3 | 7 | 0 |
| Comparative Example 4 | 850 | 41 |

As stated above, the members constituting the present boat for supporting semiconductor wafers are made substantially of a vitreous carbon, therefore, the present boat for supporting semiconductor wafers generates no dust and hardly cause the staining and dislocation defects of wafer.

## Claims

1. A process for producing an instrument for production of a semiconductor, which is composed substantially of a vitreous carbon, characterized in that the process comprises the steps of molding a polycarbodiimide resin or a composition composed mainly of a polycarbodiimide resin into a shape of an instrument for production of a semiconductor and then carbonizing the molded material in vacuum or an inert gas atmosphere.

2. A process according to claim 1, wherein said carbonization of the molded material is conducted in a temperature range of 1,000-3,000°C.

3. A process according to claim 1, wherein said instrument is a jig for semiconductor.

4. A process according to claim 3, wherein said jig is a wafer hand or a wafer holder.

5. A process according to claim 1, wherein said instrument is a semiconductor wafer dummy.

6. A process according to claim 1, wherein said instrument is a boat for supporting semiconductor wafers.

7. A process according to claim 6, wherein said boat comprises , as main members, supporting rods (1) each having grooves (5) for supporting semiconductor wafers and fixing plates (2, 3) for fixing said supporting rods.

8. A process according to claim 1, wherein said vitreous carbon have a bulk density of 1.51-1.8 g/cm³, a bending strength of 1,800-4,000 kg/cm², a Shore hardness of 121-140, a porosity of 0-0.09% and an ash content of 0-4 ppm.

9. A method for cleaning of plasma etching chamber inside and the like, which comprises fixing a wafer dummy according to claim 5, inside the chamber of a plasma etching apparatus, and then generating a plasma inside the chamber.

## Patentansprüche

1. Herstellverfahren für eine Vorrichtung zur Erzeugung eines Halbleiters, welcher sich im wesentlichen aus einem Glaskohlenstoff zusammensetzt, dadurch gekennzeichnet, daß das Verfahren die Schritte des Formens eines Polycarbodiimidharzes oder einer hauptsächlich in einem Polycarbodiimidharz bestehenden Zusammensetzung in die Form einer Vorrichtung zur Herstellung eines Halbleiters und dann des Carbonisierens des geformten Materials in Vakuum oder einer Inertgasatmosphäre umfaßt.

2. Verfahren nach Anspruch 1, wobei die Carbonisierung des geformten Materials in einem Temperaturbereich von 1.000-3.000°C durchgeführt wird.

3. Verfahren gemäß Anspruch 1, wobei die Vorrichtung eine Spannvorrichtung für Halbleiter ist.

4. Verfahren nach Anspruch 3, wobei die Spannvorrichtung ein Wafer-Greifer oder ein Wafer-Halter ist.

5. Verfahren nach Anspruch 1, wobei die Vorrichtung ein Halbleiter-Wafer-Dummy ist.

6. Verfahren nach Anspruch 1, wobei die Vorrichtung ein Floß zum Tragen der Halbleiter-Wafer ist.

7. Verfahren nach Anspruch 6, wobei das Floß, als Hauptbestandteile, Stützstäbe (1) mit jeweils Schlitzen (5) zum Einstecken der Halbleiter-Wafer und Fixierplatten (2,3) zur Fixierung der Stützstäbe umfaßt.

8. Verfahren nach Anspruch 1, wobei der Glaskohlenstoff eine Massendichte von 1,51-1,8 g/cm³, eine Biegefestigkeit von 1.800-4.000 kg/cm², eine Shore-Härte von 121-140, eine Porosität von 0-0,09% und einen Aschegehalt von 0-4 ppm aufweist.

9. Verfahren zur Reinigung einer Plasmaätzkammer im Inneren und ähnlichem, welches das Fixieren eines Wafer-Dummys nach Anspruch 5 im Inneren der Kammer eines Plasmaätzapparates und dann die Erzeugung von Plasma im Inneren der Kammer umfaßt.

## Revendications

1. Procédé de production d'un instrument pour la production d'un semi-conducteur, qui se compose sensiblement d'un carbone vitreux, caractérisé en ce que le procédé comprend les étapes de mouler une résine de polycarbodiimide ou une composition formée principalement d'une résine de polycarbodiimide en une forme d'un instrument pour la production d'un semi-conducteur puis de carboniser la matière moulée sous vide ou dans l'atmosphère d'un gaz interne.

2. Procédé selon la revendication 1 où ladite carbonisation de la matière moulée est entreprise à une température entre 1000 et 3000°C.

3. Procédé selon la revendication 1 où ledit instrument est un appareil de montage d'un semi-conducteur.

4. Procédé selon la revendication 3 où ledit appareil de montage est une main pour pastille ou un support pour pastille.

5. Procédé selon la revendication 1 où ledit instrument est une pastille factice de semi-conducteur.

6. Procédé selon la revendication 1 où ledit instrument est une coupelle pour supporter des pastilles de semi-conducteur.

7. Procédé selon la revendication 6 où ladite coupelle comprend, comme organes principaux, des tiges de support (1), chacune ayant des gorges (5) pour supporter des pastilles de semi-conducteur et des plaques de fixation (2, 3) pour fixer lesdites tiges de support.

8. Procédé de production d'un semi-conducteur selon la revendication 1 où ledit carbone vitreux a une densité apparente de 1,51-1,8 g/cm³, une résistance à la flexion de 1800-4000 kg/cm², une dureté Shore de 121-140, une porosité de 0-0,09% et une teneur en cendres de 0-4 ppm.

9. Méthode de nettoyage de l'intérieur d'une chambre d'attaque au plasma et analogue, qui consiste à fixer une pastille factice faite selon la revendication 5 à l'intérieur de la chambre d'un appareil d'attaque au plasma puis à générer un plasma à l'intérieur de la chambre.
